# EUROPEAN PATENT APPLICATION

(11) **EP 0 826 457 A1**
(43) Date of publication of application: **04.03.1998**
(21) Application number: 97305454.7
(22) Date of filing: 21.07.1997
(51) Int. Cl.: B23K 26/00

(54) **A method of drilling a hole in a workpiece**

(30) Priority: 14.08.1996 GB 9617093
(71) Applicant: ROLLS-ROYCE plc, London, SW1E 6AT (GB)
(72) Inventor: Wybrow, Michael Neil, Hucknall, Nottingham NG15 6GL (GB)

(57) **Abstract**

A hole (30) is drilled in a turbine blade (10) by laser drilling. The turbine blade (10) comprises a superalloy substrate (12), a bond coating (14) and a ceramic thermal barrier coating (16). The hole (30) is produced by firstly focusing the laser beam (26) such that the focal point (28) is on the surface of the ceramic thermal barrier coating (16) to drill a small diameter hole (18) through the turbine blade (10). The laser beam (26) is refocused such that the focal point (28) is spaced from the surface of the ceramic thermal barrier coating (16). The laser beam (26) is pulsed on and off to drill a large diameter hole (30) coaxially with the small diameter hole (18). The small diameter hole (18) allows the molten material and heat to be expelled from the hole (18) and reduces heating of the superalloy substrate (12) to reduce the thickness of the oxide layer and recast layer around the hole and prevent delamination of the ceramic thermal barrier coating (16).

## Description

The present invention relates to a method of drilling a hole in a workpiece, for example a film cooling hole in a turbine blade or turbine vane of a gas turbine engine. More particularly the invention relates to a method of drilling a hole in a workpiece using a laser beam.

It is known in the prior art to drill film cooling holes in turbine blades and turbine vanes by electrical discharge machining, by capillary drilling and by laser drilling.

Electrical discharge machining uses an electrode with a low voltage, high current power source to cut through the workpiece by spark erosion. Holes of 0.2mm diameter and larger can be produced, but the rate of drilling is slow and tooling costs are very high.

Capillary drilling uses an electrode surrounded by a concentric glass capillary tube. An electrolyte is forced down the annular gap between the electrode and the capillary tube so that when a voltage is applied across the electrode and workpiece, material is removed from the workpiece. Again holes of 0.2mm diameter and larger can be produced, but the rate of drilling is slow.

Since both electrical discharge machining and capillary drilling involve electrical conduction through the workpiece it is only possible to drill electrical conductors by means of these processes.

Laser machining uses a laser machine tool to focus a beam of high energy coherent radiation, laser light, onto the workpiece surface, hence causing material to be vaporised and expelled. Laser drilling has two variants trepanning and percussion drilling. In trepanning a continuous or pulsed laser beam is focused onto the surface of the workpiece to drill through the workpiece at one point, the laser beam is then moved through a circular path to cut the circumference of a cylindrical hole. Laser trepanning is used to drill holes with diameters greater than about 0.3mm diameter. In percussion drilling the laser beam is focused at a point spaced from the surface of the workpiece and the whole of the cross-sectional area of the laser beam on the workpiece drills through the workpiece. Also in percussion the laser beam is pulsed on and off to drill progressively through the workpiece. Laser percussion drilling is used to drill holes with smaller diameters up to about 0.6mm diameter. Laser trepanning produces a more consistent and better quality holes because it generates the hole compared to laser percussion drilling which forms the hole, however laser trepanning is slower.

It is known in the prior art to provide turbine blades and turbine vanes with ceramic thermal barrier coatings to enable the turbine blades and turbine vanes to operate at higher temperatures or to operate at conventional temperatures for longer periods.

A problem with the application of ceramic thermal barrier coatings to turbine blades and turbine vanes is that it makes the drilling of the cooling holes more difficult. The electrical discharge machining and capillary drilling processes cannot drill through the ceramic thermal barrier coatings, because the ceramic thermal barrier coating is not an electrical conductor. A laser beam will cut through the ceramic thermal barrier coating, however the laser percussion drilling of small diameter holes results in heating of the metal of the turbine blade, or turbine vane, producing an oxide layer around the periphery of the hole and a recast layer under the oxide layer and most importantly shrinkage of the metal. This shrinkage of the metal may lead to debonding of the ceramic thermal barrier coating from the turbine blade, or turbine vane, resulting in the turbine blade, or turbine vane, being scrapped.

It is known from German patent application No. DE1953612A to predrill the holes in the workpiece using a laser beam before applying the ceramic thermal barrier coating. Air is passed through the holes during deposition of the ceramic thermal barrier coating to stop the ceramic blocking the holes. This method is not ideal as the holes may be partially blocked by the ceramic thermal barrier coating. Additionally it is not possible to pass air through the holes during physical vapour deposition of the ceramic thermal barrier coating.

It is known from US patent No. US4818834 to drill holes through the ceramic thermal barrier coating using a laser beam and then to drill the holes through the metal using electrical discharge machining. This method is not ideal as the rate of drilling will be slow due to the need to change from laser drilling to electrical discharge machining and also because the electrical discharge machining is slow.

The present invention seeks to provide a novel method of drilling a hole in a workpiece which overcomes the above mentioned problems.

Accordingly the present invention provides a method of drilling a hole in a workpiece by means of a laser beam, comprising the steps of:-
(a) laser drilling a first hole through the workpiece, the first hole having a first diameter, and
(b) laser drilling a second hole, which is aligned with the first hole, through the workpiece, the second hole having a second diameter which is greater than the first diameter of the first hole.

The advantage of this method is that the small diameter hole allows the hot molten workpiece material to be expelled out of the other end of the hole, taking away the heat from the workpiece. This reduces the thickness of the oxide layer and recast layers around the hole and also reduces shrinkage of the workpiece.

Preferably step (a) comprises directing the laser beam onto the surface of the workpiece, focusing the laser beam such that the focal point is on the original surface of the workpiece to drill the first hole through the workpiece, and step (b) comprises refocusing the laser beam such that the focal point is spaced from the original surface of the workpiece to drill the second hole.

Preferably step (b) comprises pulsing the laser beam on and off. Preferably step (b) comprises moving the focal point towards the surface of the workpiece to a plurality of positions at different distances from the surface of the workpiece. Preferably step (b) comprises pulsing the laser beam on and off for a predetermined number of times at each one of the plurality of positions of the focal point.

Step (b) may comprise pulsing the laser beam on and off for the same number of times at each one of the plurality of positions of the focal point to produce a cylindrical hole. Alternatively step (b) may comprise pulsing the laser beam on and off for different number of times at each one of the plurality of positions of the focal point to produce a convergent hole or a divergent hole.

The first hole may have a diameter of about 0.2mm. The second hole may have a diameter up to about 0.6mm.

The workpiece may comprise a metal, or alloy, having a ceramic thermal barrier coating. The alloy may be a nickel superalloy or a cobalt superalloy. The ceramic thermal barrier coating may be zirconia stabilised with yttria. Preferably a bond coat is provided between the ceramic thermal barrier coating and the metal or alloy.

The bond coat may be a MCrAlY alloy, where M is Fe, Co, Ni or a mixture of Ni and Co, an aluminide or a platinum aluminide. The reduced shrinkage of the metal, or alloy, enables the hole to be drilled without debonding of the ceramic thermal barrier coating.

The workpiece may comprise a turbine blade or a turbine vane.

The present invention will be more fully described by way of example with reference to the accompanying drawings, in which:-

Figure 1 is a schematic diagram of a first stage in the method of drilling a hole in a workpiece according to the present invention.

Figure 2 is a schematic diagram of a second stage in the method of drilling a hole in a workpiece according to the present invention.

Figure 3 is a schematic diagram of a third stage in the method of drilling a hole in a workpiece according to the present invention.

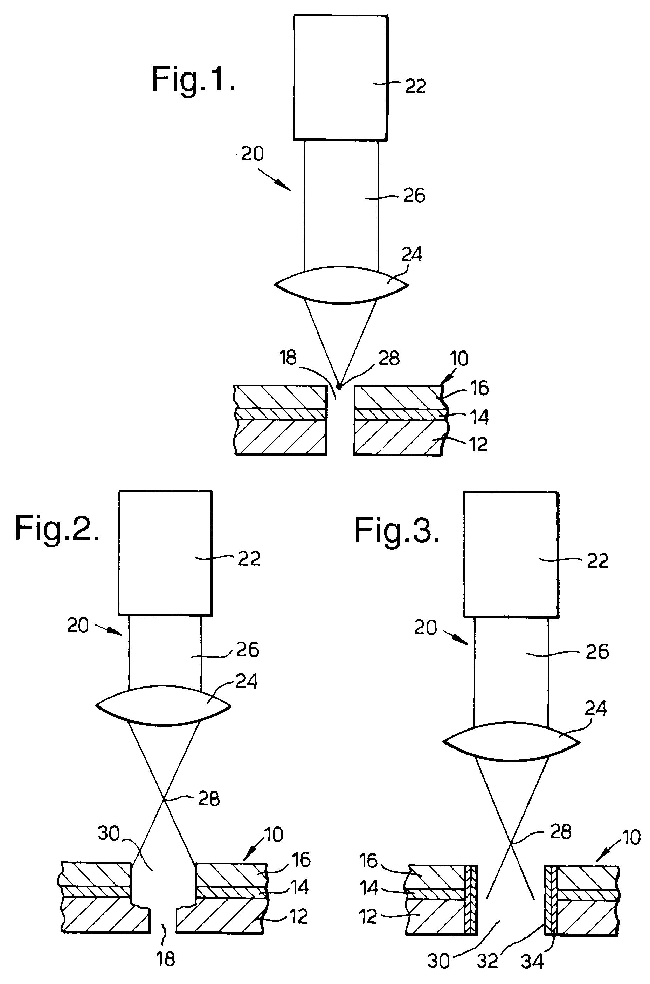

A portion of a gas turbine engine turbine blade 10 is shown in figures 1 to 3 and the turbine blade 10 comprises a superalloy substrate 12, for example a nickel superalloy or a cobalt superalloy, which has been cast into the shape of a turbine blade 10. The superalloy substrate 12 is coated with a metallic bond coat 14, for example a MCrAlY alloy bond coat where M is Fe, Co, Ni or a mixture of Co and Ni, an aluminide bond coat or a platinum aluminide bond coat. The MCrAlY bond coat 14 is applied by plasma spraying, electron beam physical vapour deposition or sputtering. The aluminide bond coat is produced by aluminising and the platinum aluminide bond coat is produced by platinum aluminising. The bond coat 14 is coated with a ceramic thermal barrier coating 16, for example zirconia stabilised with 8wt% yttria. The ceramic thermal barrier coating is applied by plasma spraying, electron beam physical vapour deposition, sputtering, chemical vapour deposition or combustion chemical vapour deposition.

An apparatus 20 to drill holes through the turbine blade 10 comprises a laser beam source 22, which comprises for example a yttrium aluminium and garnet (YAG) laser, and one or more lenses 24 to focus the laser beam 26 exiting the laser source 22 to a focal point 28.

The first step in the method of drilling the holes in the turbine blade 10 comprises focusing the laser beam 26 such that the focal point 28 is on the surface of the turbine blade 10, which in this example is the surface of the ceramic thermal barrier coating 16, as is shown in figure 1. A continuous or pulsed laser beam 26 drills a first small diameter hole 18, about 0.2mm in diameter, straight through the turbine blade 10. The laser beam 26 is focused, such that the focal point 28 is on the original surface of the turbine blade 10, by moving the lens 24 relative to the laser source 22 and the turbine blade 10. In this step the focal point 28 of the laser beam 26 is maintained on the original surface of the turbine blade 10, however if it considered necessary the focal point 28 of the laser beam 26 may be continuously or periodically moved to the new surface of the turbine blade 10 as the laser beam 26 drills through the turbine blade 10.

The second step in the method of drilling the holes in the turbine blade 10 comprises refocusing the laser beam 26 such that the focal point 28 is spaced from the original surface of the turbine blade 10 as is shown in figures 2 and 3. A pulsed laser beam 26 drills a second large diameter hole 30, up to 0.6 mm, which is coaxially aligned with the first small diameter hole 18, through the turbine blade 10. The laser beam 26 is refocused away from the original surface of the turbine blade 10 by moving the lens relative to laser source 22 and the turbine blade 10, by moving the lens 24 and laser source 22 as a unit relative to the turbine blade 10 or by other suitable methods.

The laser beam 26 is pulsed several times in the position as shown in figure 2 to drill part way through the turbine blade 10. Thereafter the focal point 28 of the laser beam 26 is moved closer to the original surface of the turbine blade 10, as shown in figure 3, to drill the remainder of the way through the turbine blade 10. It is possible to continuously or periodically move the focal point 28 of the laser beam 26 to various positions and to vary the number of pulses at each position so as to produce predetermined shapes of holes for example cylindrical, convergent from the surface of the turbine blade to the interior of the turbine blade or divergent from the surface of the turbine blade to the interior of the turbine blade.

The provision of the first small diameter hole 18 through the turbine blade 10 enables the molten ceramic, molten bond coat and molten superalloy material to be expelled out of the opposite end of the hole 18 during the percussion drilling of the second large diameter hole 30 and this takes away the heat. This results in less heating of the turbine blade 10, producing less melting of the turbine blade 10 and reducing the thickness of an oxide layer 32 and recast layer 34 around the hole 30 and reducing shrinkage of the workpiece material 12. If a ceramic thermal barrier coating 16 is applied to the turbine blade 10 the reduced shrinkage enables the ceramic thermal barrier coating 16 to remain bonded to the bond coat 14 and superalloy substrate 12 without delamination. The reduction in shrinkage is of the order of 80% less for the present invention compared to standard laser percussion drilling.

The holes may be drilled at angles from 90° to 17° relative to the surface of the turbine blade.

Although the invention has been described with reference to a turbine blade the invention is also applicable to turbine vanes, combustion chambers and other components or workpieces which require the drilling of holes. The invention is particularly suitable for drilling holes in workpieces with ceramic thermal barrier coatings in order to reduce delamination of the ceramic thermal barrier coating but is also useful for drilling holes in workpieces without ceramic thermal barrier coatings because of the reduced thicknesses of oxide layers and recast layers around the holes.

## Claims

1. A method of drilling a hole in a workpiece (10) by means of a laser beam (26), comprising the steps of:-
(a) laser drilling a first hole (18) through the workpiece (10), the first hole (18) having a first diameter,
characterised by
(b) laser drilling a second hole (30), which is aligned with the first hole (18), through the workpiece (10), the second hole (30) having a second diameter which is grater than the first diameter of the first hole (18).

2. A method as claimed in claim 1 wherein step (a) comprises directing the laser beam (26) onto the surface of the workpiece (10), focusing the laser beam (26) such that the focal point is on the original surface of the workpiece (1) to drill the first hole (18) through the workpiece (10), and step (b) comprises refocusing the laser beam (26) such that the focal point is spaced from the original surface of the workpiece (10) to drill the second hole (30).

3. A method as claimed in claim 1 wherein step (b) comprises pulsing the laser beam (26) on and off.

4. A method as claimed in claim 1, claim 2 or claim 3 wherein step (b) comprises moving the focal point towards the surface of the workpiece (10) to a plurality of positions at different distances from the surface of the workpiece (10).

5. A method as claimed in claim 4 comprising pulsing the laser beam (26) on and off for a predetermined number of times at each one of the plurality of positions of the focal point.

6. A method as claimed in claim 5 comprising pulsing the laser beam (26) on and off for the same number of times at each one of the plurality of positions of the focal point to produce a cylindrical hole (30).

7. A method as claimed in claim 5 comprising pulsing the laser beam (26) on and off for different number of times at each one of the plurality of positions of the focal point to produce a convergent hole or a divergent hole.

8. A method as claimed in any of claims 1 to 7 wherein step (a) comprises pulsing the laser (26) beam on and off.

9. A method as claimed in any of claims 1 to 8 wherein step (a) comprises moving the focal point from the original surface of the workpiece (10) to the new surface of the workpiece (10).

10. A method as claimed in any of claims 1 to 9 wherein the first hole (18) has a diameter of about 0.2mm.

11. A method as claimed in any of claims 1 to 10 wherein the second hole (30) has a diameter up to about 0.6mm.

12. A method as claimed in any of claims 1 to 11 wherein the workpiece (10) comprise a metal, or alloy, having a ceramic thermal barrier coating (16).

13. A method as claimed in claim 12 wherein the alloy is a nickel superalloy or a cobalt superalloy.

14. A method as claimed in claim 12 or claim 13 wherein the ceramic thermal barrier coating (16) is zirconia stabilised with yttria.

15. A method as claimed in any of claims 12 to 14 wherein a bond coat (14) is provided between the ceramic thermal barrier coating (16)and the metal or alloy (12).

16. A method as claimed in claim 15 wherein the bond coat (14) is a MCrAlY alloy, where M is Fe, Co, Ni or a mixture of Ni and Co, an aluminide or a platinum aluminide.

17. A method as claimed in any of claims 1 to 16 wherein the workpiece (10) comprises a turbine blade or a turbine vane.

18. A method as claimed in any of claims 1 to 16 wherein the workpiece (10) comprises a combustion chamber.
